(19) Europäisches Patentamt

European Patent Office

Office européen des brevets

(11) EP 2 993 480 A1

(12) EUROPEAN PATENT APPLICATION

(43) Date of publication:
09.03.2016 Bulletin 2016/10

(51) Int Cl.:
G01R 15/06 (2006.01)     G01R 15/16 (2006.01)

(21) Application number: 14183485.3

(22) Date of filing: 04.09.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: 3M Innovative Properties Company
Saint Paul, MN 55133-3427 (US)

(72) Inventors:
- **Stalder, Michael Heinz**
  **47589 Uedem (DE)**
- **Hampe, Andreas**
  **41065 Mönchengladbach (DE)**
- **Muenstermann, Benjamin**
  **47055 Duisburg (DE)**
- **Weinmann, Christian**
  **52477 Alsdorf (DE)**
- **Eggert, Sebastian**
  **69115 Heidelberg (DE)**
- **Kurzhals, Holger Joerg**
  **47839 Krefeld (DE)**
- **Gravermann, Mark**
  **41812 Erkelenz (DE)**
- **Weichold, Jens**
  **41812 Erkelenz (DE)**
- **Chalupka, Mark**
  **40764 Langenfeld (DE)**

(74) Representative: **Müller, Bruno**
**3M Deutschland GmbH**
**Carl-Schurz-Straße 1**
**41453 Neuss (DE)**

(54) **Voltage sensor**

(57)     Voltage sensing assembly (1), comprising a conductor assembly (10) having a power conductor (40) for conducting power in a high- or medium voltage power network, and a sensor circuit (20) for sensing an alternating voltage of the power conductor. The sensor circuit comprises

a) a sensing capacitor (100) having a capacitance and comprising a first sensing electrode (60), a dielectric, and a second sensing electrode electrically connected with the power conductor or comprising a portion of the power conductor; and

b) a measurement impedance (110), electrically arranged, in series with the sensing capacitor, between the first sensing electrode and electrical ground such that the sensing capacitor and the measurement impedance form a voltage divider.

The sensor circuit can be brought into a measurement configuration, in which a measurement current, flowing through the measurement impedance, is indicative of the voltage of the power conductor versus ground. The sensor circuit can be brought into a calibration configuration, in which a calibration current, flowing through the first sensing electrode, is indicative of the capacitance of the sensing capacitor.

FIG. 1

EP 2 993 480 A1

**Description**

The invention relates to voltage sensors, and specifically to electrical circuits, devices and methods for calibrating voltage sensors for medium- and high-voltage power cables and other high-voltage or medium-voltage conductor assemblies for conducting power in a power network like a national grid.

Measuring the voltage in high-voltage or medium-voltage conductor assemblies in power networks, such as power cables or bus bars, requires special techniques, because voltages and currents are high. Generally it is considered advantageous to use voltage sensors that do not require a galvanic contact with the inner conductor (i.e. the power conductor) of the conductor assembly, because such sensors typically pose less safety risks. Sensors that are based on capacitive voltage dividers have been employed in the past. In such sensors, a sensing capacitor and a measurement impedance (e.g. a resistor, an inductivity or a capacitor) are connected in series, their electrical properties determining the dividing ratio of the voltage divider. The sensing capacitor provides for galvanic separation from the power conductor. A measurement voltage, picked up across the measurement impedance, is generally proportional to the voltage of the power conductor of the conductor assembly versus electrical ground.

Upon assembly of the sensor, the sensing capacitor has a certain capacitance. After assembly, the capacitance of the sensing capacitor can be affected by aging, mechanical impacts like torsion or pressure. Also, when transmitting power, power cables and other conductor assemblies often become hot. Generally, changes in temperature of the sensing capacitor can result in a change of its electrical capacitance, which, in turn, leads to a change in the dividing ratio and to a change of the proportionality factor between the measurement voltage and the voltage of the power conductor. Directly measuring the capacitance of the sensing capacitor can normally not be done while the power conductor is in service because this would require galvanic contact with the high voltage power conductor. Galvanic contact, in turn, often poses safety risks and/or requires comprehensive measures for electrical insulation. Therefore, a temperature correction is often performed on the sensor results, in order to compensate for the change in capacitance of the sensing capacitor and thus to determine the voltage of the power conductor with a higher accuracy.

One approach to temperature compensation is described in U.S. Patent 4,241,373, in which, in a switchgear voltage sensor, a thermistor and a resistor serve as a temperature compensating network to compensate for temperature-induced changes in the dielectric properties of a cast epoxy which is disposed between a voltage sensing plate and a connector stud, and which serves as the dielectric of a capacitor.

The European patent application EP 2508898 A1, as a further example, describes a capacitive sensor arrangement on a cable using pre-existing structures within the cable. It is stated that temperature correction techniques may be added, either through direct measurement of the sensor temperature and correcting in the signal conditioning, or adding a temperature-dependent element that corrects the deviation in the signal conditioning.

For higher accuracy, it is desirable to be able to determine the value of the capacitance of the sensing capacitor while the conductor assembly is in service, i.e. without having to disconnect the conductor assembly from the power network. It is also desirable to determine the value of the capacitance of the sensing capacitor without requiring a galvanic contact with the power conductor of the conductor assembly.

The present invention provides a voltage sensing assembly comprising a conductor assembly having a power conductor for conducting power in a high- or medium voltage power network, and a sensor circuit for sensing an alternating voltage of the power conductor, wherein the sensor circuit comprises

a) a sensing capacitor having a capacitance and comprising a first sensing electrode, a dielectric, and a second sensing electrode electrically connected with the power conductor or comprising a portion of the power conductor; and
b) a measurement impedance, electrically arranged in series with the sensing capacitor between the first sensing electrode and electrical ground such that the sensing capacitor and the measurement impedance form a voltage divider,

wherein the sensor circuit can be brought into a measurement configuration, in which a measurement current, flowing through the measurement impedance, is indicative of the voltage of the power conductor versus ground, characterized in that the sensor circuit can be brought into a calibration configuration, in which a calibration current, flowing through the first sensing electrode, is indicative of the capacitance of the sensing capacitor.

The voltage divider formed by the sensing capacitor and the measurement impedance can be used for determining the voltage of the power conductor versus ground. For accurate determination of the voltage of the power conductor, the electrical capacitance of the sensing capacitor needs to be known precisely at the time of the measurement. According to the invention, the sensor circuit is brought into a calibration configuration, so that a calibration current flows through the first sensing electrode. A measurement of the magnitude of this calibration current, or of the magnitude of a corresponding voltage drop across a known reference impedance, allows for a precise determination of the capacitance of the sensing capacitor without requiring galvanic contact with the power conductor.

The conductor assembly, e.g. a high-voltage (HV) or medium-voltage (MV) power cable, generally becomes warm when it carries electrical power. Depending on the current through the power conductor, the temperature of the conductor assembly varies. Because the sensing capacitor comprises the power conductor as its second electrode or is electrically connected with the power conductor, its temperature varies with the temperature of the power conductor. It is quite often not possible to arrange the sensing capacitor in a location where it is not affected by these temperature variations of the conductor assembly. The temperature of the sensing capacitor may also be affected by other factors, like, for example, environmental temperature or the absence or presence of active cooling. Generally, a rise in temperature can cause an expansion of the dielectric of the sensing capacitor which results in a larger distance between the capacitor electrodes and a change in capacitance. Also, the permittivity of the dielectric may change with temperature. The capacitance of the sensing capacitor thus generally varies with the amount of power transmitted by the power conductor.

The sensor circuit allows for a direct determination of the capacitance of the sensing capacitor without having to galvanically contact the second sensing electrode, which is on a medium or high voltage, and which may be the HV/MV power conductor itself. This determination is instantaneous, meaning that determination is performed within a very short time interval compared to time intervals in which temperature changes affect the capacitance. The determination of the capacitance is also independent from predefined or static lookup tables and calibration curves. It is therefore generally more accurate than indirect measurements or time-delayed measurements. A more accurate determination of the capacitance of the sensing capacitor is a prerequisite for more precise knowledge of the dividing ratio of the voltage divider. A precise knowledge of the dividing ratio, in combination with precise knowledge of the impedance value of the measurement impedance and a precise determination of the measurement current, generally results in a higher accuracy of the determination of the voltage of the power conductor versus ground.

The voltage sensing assembly according to the current invention comprises a conductor assembly and a sensor circuit. The conductor assembly may comprise, for example, a power cable, such as a HV or MV power cable. Such power cables are used for transmitting electrical power in power networks like national grids. A power cable may comprise a central or inner conductor, i.e. a power conductor. The power cable may further comprise an insulation layer, such as a main insulation layer. The insulation layer may be arranged around the power conductor or around at least a portion of the power conductor. It may be arranged around and directly on the power conductor. The power cable may further comprise a conductive or semiconductive layer ("(semi-) conductive layer"), arranged around the insulation layer, optionally directly on the insulation layer. The (semi-) conductive layer may be a layer of lower conductivity, and may not necessarily comprise semiconductive material. The conductor assembly may alternatively comprise a bus bar, for example such as bus bars used for connections in transformers, switch gears or other electrical installations.

The sensor circuit comprises a sensing capacitor and a measurement impedance. The sensing capacitor and the measurement impedance form a voltage divider for dividing the voltage of the power conductor versus ground. The sensing capacitor may be operated on the high-voltage side of the voltage divider, i.e. it may be the high-voltage capacitor in the voltage divider. The measurement impedance may be operated on the low-voltage side of the voltage divider, i.e. it may be the low-voltage impedance in the voltage divider The sensing capacitor has a first and a second sensing electrode and a dielectric. According to the invention, the second sensing electrode is electrically connected with the power conductor. The second sensing electrode may be an element separate from the power conductor. The second sensing electrode may be galvanically connected with the power conductor. The second sensing electrode may be arranged radially outward of the power conductor. It may be of cylindrical shape. It may be arranged concentrically around the power conductor. The second sensing electrode may be electrically and/or galvanically connected with the power conductor via a contact element. The contact element may be resilient.

The second sensing electrode may comprise a portion of the power conductor. Where the conductor assembly is a power cable, the second sensing electrode may, for example, comprise a portion of an inner conductor of the power cable. The second sensing electrode, the first sensing electrode and a dielectric, arranged between the first and the second sensing electrode, form the sensing capacitor. Generally, the electrodes of a capacitor are separated by a non-conductive dielectric and are therefore considered to be galvanically not connected.

The first sensing electrode of the sensing capacitor may be arranged radially outward from the second sensing electrode, relative to the power conductor. The first sensing electrode may comprise a conductive coating or a conductive layer. Where the conductor assembly comprises an insulation layer arranged coaxially around the power conductor, the first sensing electrode may be arranged radially outward of the insulation layer and/or on the insulation layer. Where the conductor assembly comprises a power cable having an insulation layer, the first sensing electrode may comprise a conductive sleeve, arranged concentrically around the insulation layer. The sleeve may extend about a full circumference of the insulation layer or about a portion of the circumference. Generally, where the conductor assembly comprises a power cable having an insulation layer arranged coaxially around the power conductor and a (semi-) conductive layer arranged on the insulation layer, the first sensing electrode may comprise a portion of the (semi-) conductive layer. The portion may be galvanically separated from other portions of the (semi-) conductive layer of the power cable. The portion may be a pre-existing portion of the (semi-) conductive layer of the power cable, i.e. it is comprised in the cable as a regular (semi-) conductive layer of the power cable. The first sensing electrode may be formed from a portion of the (semi-) conductive layer of the cable. Alternatively, the first sensing electrode may be formed separately from the (semi-) conductive layer of the cable. The first sensing electrode may comprise a conductive layer on the insulation layer of the power cable having a different electrical conductivity than a pre-existing (semi-) conductive layer of the power cable.

The dielectric of the sensing capacitor may be arranged radially outward of the power conductor. The dielectric of the sensing capacitor may be arranged radially outward of the second sensing electrode. It may be arranged directly on the second sensing electrode or it may be separated from the second sensing electrode by one or more layers or by one or more gaps. Where the conductor assembly comprises a power cable having an insulation layer, the dielectric may comprise a portion of the insulation layer. The dielectric may comprise a portion of a main insulation layer of the power cable. In any case, the portion may be a pre-existing portion of an insulation layer of the power cable, i.e. it is comprised in the cable as a regular insulation layer of the power cable, such as a main insulation layer. Alternatively, the dielectric may be formed separately from the insulation layer of the power cable. It may have a permittivity, expressed in the dielectric constant $\varepsilon_R$, which is different from the permittivity of a pre-existing insulation layer of the power cable.

A further element of the sensor circuit is the measurement impedance. The measurement impedance may be, or it may comprise, a resistor. The measurement impedance may be, or it may comprise, a capacitor. The measurement impedance may be, or it may comprise, an inductance. Generally, the measurement impedance may be formed by a single capacitor, inductance or resistor, or by a combination of one or more capacitors and/or one or more inductances, and/or one or more resistors. For a given alternating voltage of the power conductor and a given capacitance of the sensing capacitor, the electrical properties of the measurement impedance (i.e., the resistance of a resistor, the capacitance of a capacitor, the inductivity of an inductance) may be selected such that the measurement current, flowing through the measurement impedance, causes a voltage drop of between 0.1 Volt and 50 Volts across the measurement impedance.

According to the invention, the measurement impedance is electrically arranged between the first sensing electrode and electrical ground. The measurement impedance may be electrically arranged between the first sensing electrode and electrical ground in the measurement configuration or in the calibration configuration or in both. Further electrical components may be electrically arranged between the first sensing electrode and the measurement impedance and/or between the measurement impedance and ground. If that is the case, the measurement impedance is still considered to be electrically arranged between the first sensing electrode and electrical ground.

In the measurement configuration of the sensor circuit, a measurement current flowing through the measurement impedance is indicative of the voltage of the power conductor versus ground. A measurement current flowing through the measurement impedance, may be indicative of the voltage of the second sensing electrode versus ground. The measurement current flowing through the measurement impedance may, for example, be proportional, to the voltage of the second sensing electrode or to the voltage of the power conductor versus ground.

The electrical parameter of the measurement impedance, i.e. the capacitance of a capacitor or the resistance of a resistor or the inductance of an inductivity forming the measurement impedance, may be known to an accuracy of 1%, 0.5%, 0.1% or better.

The sensing capacitor and the measurement impedance form a voltage divider. The capacitance of the sensing capacitor and the resistance and/or capacitance and/or the inductance of the measurement impedance may be selected such that the dividing ratio of the voltage divider circuit is between 1/100 and 1/1 000 000.

A voltage sensing assembly according to the invention comprises a sensor circuit. An element or elements of the sensor circuit may be electrically connectable with the first sensing electrode of the sensing capacitor and/or with the measurement impedance. An element or elements of the sensor circuit may be connectable to the first sensing electrode of the sensing capacitor and/or with the measurement impedance either directly or indirectly, i.e. via other electrical components. An element or elements may be electrically connected with the first sensing electrode of the sensing capacitor and/or with the measurement impedance, e.g. they may be permanently connected or they may be removably connected.

Mechanically, the sensor circuit, or one or more electrical elements of it, may be arranged in the vicinity of the sensing capacitor and/or of the first sensing electrode, e.g. at a distance of 5 cm or less, or at a distance of 10 cm or less. The sensor circuit, or an electrical element of it, may be permanently arranged in the vicinity of the sensing capacitor and/or of the first sensing electrode. In this case, the sensor circuit, or an electrical element of it, is thus not only temporarily arranged in the vicinity of the sensing capacitor and/or of the first sensing electrode, as would be the case with a measurement tool.

Some or all other electrical elements of the sensor circuit, e.g. a measurement impedance and/or a calibration impedance, may be thermally isolated from the sensing capacitor and/or from the first sensing electrode. The sensor circuit, or electrical elements of it, may be thermally isolated from the voltage divider and/or from the conductor assembly. Alternatively, an element or elements of the sensor circuit may be thermally coupled to the sensing capacitor and/or to the first sensing electrode.

In the calibration configuration and/or in the measurement configuration the second sensing electrode may be galvanically separated from all other elements of the sensor circuit. In particular, the power conductor may be galvanically separated from all other elements of the sensor circuit. Certain or all elements of the sensor circuit may be galvanically separated from the power conductor. All elements of the sensor circuit except the sensing capacitor, may be galvanically separated from the power conductor. Galvanic separation may be achieved by a capacitor, e.g. by the sensing capacitor, as is known in the art.

A sensor circuit according to the invention comprises one or more electrical elements: A sensor circuit may, for example, comprise a resistor, called a calibration resistor herein. A sensor circuit may, for example, comprise a capacitor, called a calibration capacitor herein. A sensor circuit may, for example, comprise an inductance, called a calibration inductance herein. A sensor circuit may, for example, comprise a voltage source, called a calibration voltage source herein. A calibration voltage source may supply a voltage to the sensor circuit. A calibration voltage source may be, or comprise, a device called a voltage source in some technical contexts, which keeps a set voltage constant at its output terminals. A calibration voltage source may be, or comprise, a device called a current source in some technical contexts, which keeps a set current constant at its output terminals. A sensor circuit may, for example, comprise a current source, called a calibration current source herein. A sensor circuit may comprise a voltage measurement device. A sensor circuit may comprise a current measurement device for measuring the calibration current.

Bringing the sensor circuit into the calibration configuration may be done by removing an electrical bridge or a bypass across a calibration resistor, across a calibration capacitor, or across a calibration inductance. Bringing the sensor circuit into the calibration configuration may, for example, be done by connecting a calibration resistor and/or a calibration capacitor and/or a calibration inductance to the sensor circuit.

The sensor circuit of a voltage sensing assembly according to the invention may be brought into the calibration configuration from the measurement configuration. It may be brought into the measurement configuration from the calibration configuration. It may be brought into the calibration configuration by operating an electrical switch or by operating two or more switches. It may be brought into the calibration configuration by activating or deactivating a voltage source, e.g. a calibration voltage source, or a current source, e.g. a calibration current source. It may be brought into the calibration configuration by connecting or disconnecting a resistor, e.g. a calibration resistor, a capacitor, e.g. a calibration capacitor, and/or an inductance, e.g. a calibration inductance. Generally, the sensor circuit may be brought into the calibration configuration by modifying the measurement configuration of the sensor circuit.

The sensor circuit can be brought into a calibration configuration, in which a calibration current, flowing through the first sensing electrode, is indicative of the capacitance of the sensing capacitor. The calibration current may be indicative of the capacitance of the sensing capacitor when other electrical elements of the sensor circuit are known and their electrical properties are taken into account. Generally, the calibration current may flow through the first sensing electrode to ground. The calibration current may flow through the measurement impedance. The calibration current may flow through a calibration resistor, and/or through a calibration capacitor, and/or through a calibration inductance.

The conductor assembly may comprise an insulation layer arranged coaxially around the power conductor. The conductor assembly may comprise a pre-existing insulation layer arranged coaxially around the power conductor. The dielectric of the sensing capacitor may comprise a first portion of the insulation layer. This may be beneficial because an insulation layer, e.g. of a cable forming the conductor assembly, is present on many conductor assemblies anyway. Many MV/HV power cables have an insulation layer arranged around the power conductor. Using a portion of such a pre-existing insulation layer as dielectric of the sensing capacitor is a very cost-effective way to obtain the dielectric of the sensing capacitor. It avoids the need to provide a dielectric separately. Also, a pre-existing insulation layer is normally arranged around the power conductor in a way such as to avoid air bubbles and voids. Such air bubbles and voids might cause electrical breakdowns through the insulation layer, or make such breakdowns more likely.

In the calibration configuration, all elements of the sensor circuit, except the second sensing electrode, may be galvanically separated from the power conductor. An element or elements of the sensor circuit may be electrically connected with the power conductor and galvanically separated from the power conductor. Such galvanic separation minimizes the number of electrical elements in the sensor circuit that are on the high or medium voltage of the power conductor. Thereby, such galvanic separation may allow for determination of the capacitance of the sensing capacitor without having to add insulation material and/or stress control material to the voltage sensing assembly that would help avoid an excessive concentration of electrical field lines and the associated electrical stress. Such electrical stress implies an increased risk of electrical breakdown between the high voltage present in the power conductor and potentially the second sensing electrode, and electrical elements on a lower voltage.

The first sensing electrode may be arranged at a distance of 10 centimeters or less from the power conductor. The distance may be measured radially from the power conductor. Arranging the first sensing electrode in the vicinity of the power conductor, like, for example, at a distance of 10 cm or less, may allow to accommodate the first sensing electrode along with a portion of the power conductor or along with a portion of the conductor assembly in a housing, in a receiving space formed by a cover, in a cable splice device or in a cable joint device. The housing or splice device or joint device may specifically be, for example, a cable closure.

The sensor circuit may be able to be brought from the measurement configuration into the calibration configuration by operating at least one switch. The sensor circuit may be able to be brought from the calibration configuration into the measurement configuration by operating at least one switch. The switch may be a mechanically-operated switch or, more preferred, an electrically or electronically operated switch, e.g. a transistor or a relay. The use of a switch for bringing the sensor circuit from one configuration into another is beneficial in that it may allow a quick, controlled, and simple transition between configurations. An electrically or electronically operated switch may bring particular advantages because it may allow to go into calibration configuration in an automated way, e.g. in reaction to a signal from a particular sensor, or after a specified time interval, and without requiring human intervention.

The sensor circuit may be adapted such that it can be brought from the measurement configuration into the calibration configuration. The sensor circuit may be adapted such that, for the same voltage of the power conductor, a first current flows through the first sensing electrode when the sensor circuit is in the measurement configuration, and that a second current, the calibration current, flows through the first sensing electrode when the sensor circuit is in the calibration configuration. The first current may be higher or lower than the second current or, generally, it may be different from the second current, when the voltage of the power conductor is the same. The difference between the first and the second current may be indicative of the capacitance of the sensing capacitor.

Generally, a voltage sensing assembly according to the invention may further comprise a housing or a cover forming a receiving space. The sensing capacitor and/or a portion of the conductor assembly may be arranged in said housing or in said receiving space. A cover or a housing may provide protection against environmental impacts for the sensing capacitor and/or a portion of the conductor assembly. Where the conductor assembly is a power cable, the cover or the housing may provide protection for a longitudinal section of the cable in which the cable has been stripped.

The sensor circuit may comprise a calibration resistor. The calibration resistor may be electrically arranged in series with the measurement impedance, when the sensor circuit is in the calibration configuration. Alternatively, the calibration resistor may be electrically arranged in parallel to the measurement impedance. Generally, resistors are available at comparatively low cost and with high accuracy ratings. A calibration circuit comprising a calibration resistor may therefore be cost-effective and provide high accuracy at the same time. This in turn may allow for a precise determination of the capacitance of the sensing capacitor at reasonable cost. An electrical arrangement of a calibration resistor in series with the measurement impedance or in parallel to the measurement impedance is advantageous because such an arrangement may not require active components for determining the capacitance of the sensing capacitor.

Generally, and independent from other features, the sensor circuit may comprise a calibration voltage source. The calibration voltage source may be, for example, a power supply or a battery. A calibration voltage source may provide AC voltage or DC voltage, e.g. between its output contacts, when it is activated. It may provide an electrical short, e.g. between its output contacts, when it is deactivated. Having a calibration voltage source in the sensor circuit may be beneficial in that it may allow to modify a voltage level in the sensor circuit such that the calibration current is within a desired range. The calibration voltage source may provide an adjustable voltage output. Different voltage output levels of the calibration voltage source may allow for measurement of the capacitance of the sensing capacitor at different calibration currents. This may allow for a more precise determination of the capacitance of the sensing capacitor.

The calibration voltage source may be electrically arranged in series with, or parallel to, the measurement impedance, when the sensor circuit is in the calibration configuration. In certain embodiments of the invention, an arrangement in series allows for a particularly easy adjustment of the calibration current to a desired value. An arrangement in parallel may allow for an increased accuracy in the determination of the capacitance of the sensing capacitor.

Generally, and independent from other features, the sensor circuit may comprise a calibration capacitor. The calibration capacitor may comprise a first electrode, a second electrode and a dielectric. The calibration capacitor may be electrically arranged parallel with the sensing capacitor or it may be electrically arranged in series with the sensing capacitor, when the sensor circuit is in the calibration configuration. Such electrical arrangements may allow to determine the capacitance of the sensing capacitor without having to measure the calibration current through the measurement impedance. This, in turn, may provide greater flexibility in geometric arrangement of the measurement impedance, and/or may reduce the accuracy requirements for the measurement impedance in certain embodiments. The first electrode of the calibration capacitor may be arranged concentrically around the power conductor.

In embodiments where the conductor assembly comprises an insulation layer, the dielectric of the calibration capacitor may comprise a portion of the insulation layer. This may be beneficial in that an element of the conductor assembly is used as the dielectric, so that no dedicated dielectric needs to be provided. In certain embodiments, the conductor assembly may comprise a pre-existing insulation layer. The dielectric of the calibration capacitor may then comprise a portion of the pre-existing insulation layer. This use of pre-existing elements may allow for a cost-effective production of a voltage sensing assembly according to the invention and/or for a rugged electrical design. In embodiments where the dielectric of the sensing capacitor comprises a first portion of the insulation layer, the dielectric of the calibration capacitor may comprise a second portion of the insulation layer.

The second electrode of the calibration capacitor may be electrically and/or galvanically connected with the second sensing electrode by a portion of the power conductor. Such an electrical arrangement may permit a cost-effective design of the sensor circuit, especially in embodiments where the power conductor is a pre-existing element, e.g. a pre-existing element of a power cable. Such an electrical arrangement may also help ensure that the sensing capacitor and the calibration capacitor are reliably electrically coupled with each other. The arrangement may result in the sensing capacitor and the calibration capacitor being electrically connected in series by at least a portion of the power conductor.

Generally, and independent of other features, the calibration capacitor may be thermally coupled to the sensing capacitor. It may be permanently thermally coupled. In certain embodiments, this thermal coupling may be achieved by a thermally conductive connection between the dielectric of the sensing capacitor and the dielectric of the calibration capacitor. In certain embodiments, the thermal coupling may be achieved by a thermally conductive connection between the second sensing electrode and the second electrode of the calibration capacitor. Thermal coupling is beneficial in that the calibration capacitor may then undergo the same thermal effects as the sensing capacitor. This, in turn, may allow for a higher accuracy in determining the capacitance of the sensing capacitor. Generally, and independent of other features, the conductor assembly may comprise a medium-voltage or high-voltage power cable or a portion of a medium-voltage or high-voltage power cable. A portion of a cable may be, for example, an axial section of the cable. The power conductor of the conductor assembly may comprise an inner conductor of the power cable or a portion of an inner conductor of the power cable. This may be beneficial in that the conductor assembly comprises a pre-existing element like, for example, a cable or a portion of a cable. This in turn may make it straight forward and cost-effective to determine a voltage of an inner conductor of the cable to a high degree of accuracy. One or more pre-existing elements of a cable may be used as elements of a voltage sensing assembly according to the present invention.

Alternatively, the conductor assembly may comprise a bus bar. The power conductor of the conductor assembly may comprise a conductor of the bus bar or a portion of a conductor of the bus bar. In this way, the voltage sensing assembly according to the invention allows determination of the voltage of a conductor of the bus bar.

The conductor assembly may comprise an insulation layer, as described above. The insulation layer may be arranged on the power conductor. If the conductor assembly comprises an insulation layer, the first sensing electrode may be arranged directly on the insulation layer. An arrangement of the first sensing electrode directly on the insulation layer is beneficial in that no further layers are required, so that the assembly may be very cost effective. An insulation layer may be, for example, the main insulation layer of the conductor assembly, like the main insulation layer of a power cable.

Alternatively, the first sensing electrode may be arranged radially outward of the insulation layer, and separated from the insulation layer by at least one intermediate layer. Such an intermediate layer may, for example, be a layer of adhesive for fixing the first sensing electrode on the insulation layer.

In a further aspect, the present invention also provides a method of determining the capacitance of a sensing capacitor, comprised in a sensor circuit for sensing a voltage of a conductor assembly for conducting power in a high- or medium voltage power network, wherein the sensing capacitor has a capacitance and comprises a second sensing electrode, galvanically connected with a power conductor of the conductor assembly, a dielectric, and a first sensing electrode, and wherein a measurement impedance is electrically connected between the first sensing electrode and electrical ground, the sensing capacitor and the measurement impedance forming a voltage divider, the method comprising the steps, in this sequence, of

  a) bringing the sensor circuit into a calibration configuration and determining a value of a calibration current flowing through the second sensing electrode at a given voltage of the inner conductor versus ground,
  b) calculating the capacitance of the sensing capacitor by using the value of the calibration current.

The sensor circuit may be brought from the measurement configuration into the calibration configuration by electrically connecting a calibration circuit to the first sensing electrode and/or to the measurement impedance. The present invention also provides a voltage sensing assembly comprising a conductor assembly having a power conductor for conducting power in a high- or medium voltage power network, and a voltage divider circuit for sensing an alternating voltage of the power conductor, wherein the voltage divider circuit comprises

  a) a sensing capacitor having a capacitance and comprising a first sensing electrode, a dielectric, and a second sensing electrode electrically connected with the power conductor or comprising a portion of the power conductor; and
  b) a measurement impedance, electrically arranged between the first sensing electrode and electrical ground such that a measurement current, flowing through the measurement impedance, is indicative of the voltage of the power conductor versus ground,

characterized in that the voltage sensing assembly further comprises a calibration circuit, electrically connectable with the first sensing electrode or with the measurement impedance, which calibration circuit can be brought into an activated state such that, when the calibration circuit is in the activated state and connected with the first sensing electrode or with the measurement impedance, a calibration current flows through the first sensing electrode, which calibration current is indicative of the capacitance of the sensing capacitor.

The calibration circuit may be galvanically separated from the power conductor. It may be galvanically separated from the power conductor when the calibration circuit is not electrically connected with the first sensing electrode or with the measurement impedance. It may be galvanically separated from the power conductor when the calibration circuit is electrically connected with the first sensing electrode or with the measurement impedance.

In the context of this disclosure, a first value is considered indicative of a second value if the first value can be used to determine, compute, calculate, estimate the second value. If the first value can be used in a lookup table, in a formula or in a mathematical expression to compute or calculate or determine the second value, the first value is considered to be indicative of the second value.

The voltage of the power conductor is an alternating (or "AC") voltage, and the measurement current and the calibration current are typically alternating (or "AC") currents.

The invention will now be described in more detail with reference to the following Figures exemplifying particular embodiments of the invention:

Fig. 1    Figurative circuit diagram of a first voltage sensing assembly according to the invention, comprising a calibration resistor;

Fig. 2    Figurative circuit diagram of a second voltage sensing assembly according to the invention;

Fig. 3    Figurative circuit diagram of a third voltage sensing assembly according to the invention, comprising a separate second sensing electrode;

Fig. 4    Figurative circuit diagram of a fourth voltage sensing assembly according to the invention, comprising a calibration voltage source;

Fig. 5    Figurative circuit diagram of a fifth voltage sensing assembly according to the invention, comprising a calibration capacitor; and

Fig. 6    Figurative circuit diagram of a sixth voltage sensing assembly according to the invention.

In the Figures, like elements are provided with the same reference numbers.

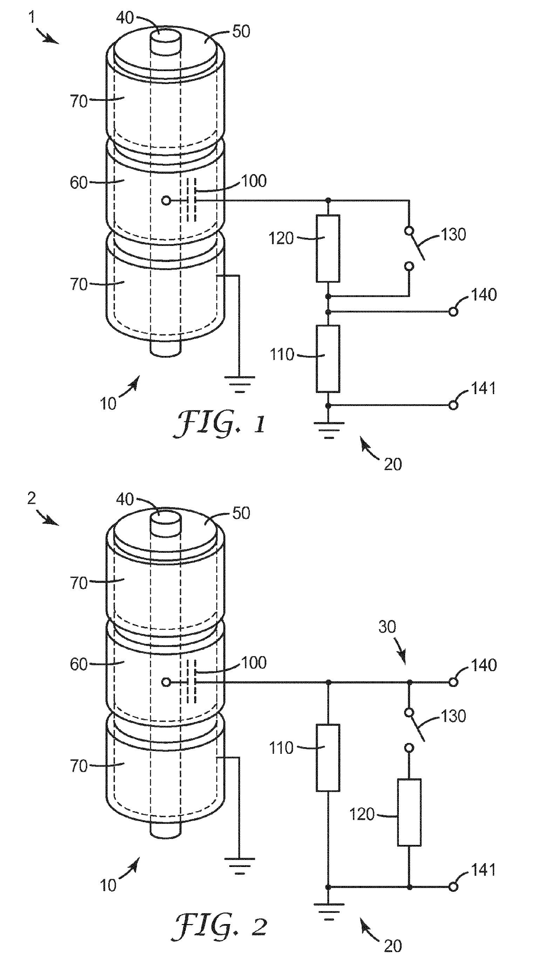

**Figure 1** is a figurative circuit diagram showing a first voltage sensing assembly 1 according to the invention. A medium-voltage power cable 10 is sketched in perspective view on the left side, a circuit diagram of a sensor circuit 20 is drawn on the right side of Figure 1.

The power cable 10 comprises an inner conductor 40 and an insulation layer 50, coaxially arranged around the inner conductor 40. A sleeve-shaped electrode 60 is arranged radially outward of the insulation layer 50. In this embodiment, the electrode 60 is arranged on the insulation layer 50, but in other embodiments, intermediate layers may exist. The electrode 60 forms a first sensing electrode 60 of a sensing capacitor 100, which sensing capacitor 100 further comprises the inner conductor 40 as the second sensing electrode, and a portion of the insulating layer 50 as its dielectric. The capacitor symbol 100 in the circuit diagram of Figure 1 does thus not represent an additional capacitor, but represents the sensing capacitor 100, electrically formed by the inner conductor 40, the first sensing electrode 60, and the insulating layer 50. The sensing capacitor 100 can be operated to sense a voltage of the inner conductor 40 versus electrical ground. It can be operated as a capacitor, e.g. a high-voltage capacitor, in a voltage divider, which voltage divider further comprises the measurement resistor 110, more generally a resistor or a capacitor or an inductance or generally a measurement impedance, for dividing the voltage of the inner conductor 40 versus ground.

The inner conductor 40 comprises solid aluminium and is designed for currents of 50 Ampere (A) or more at voltages of 10 kilovolt (kV) or higher. The insulating layer 50 comprises a polymeric material. The insulating layer 50 may be formed by a portion of the pre-existing insulating layer of the cable 10 or alternatively it may have been applied in a separate step. The first sensing electrode 60 comprises a layer of conductive metal, affixed to the radially outer surface of the insulating layer 50. The voltage sensing assembly 1 shown in Figure 1 comprises also two auxiliary electrodes 70, arranged on the insulating layer 50 of the power cable 10, axially offset from the first sensing electrode 60 in respective opposite axial directions, and electrically isolated from the first sensing electrode 60. The auxiliary electrodes 70 are electrically connected to ground. The auxiliary electrodes 70 provide for a more homogenous electrical field between the inner conductor 40 and the first sensing electrode 60. They also shape the electrical field such that a concentration of field lines and steep local voltage gradients are reduced.

The sensor circuit 20 comprises the sensing capacitor 100 and the measurement resistor 110, the calibration resistor 120 and a switch 130. The calibration resistor 120 can be activated, i.e. electrically added to the voltage divider, by opening the switch 130. The calibration resistor 120 can be deactivated, i.e. bridged, or bypassed, and thereby electrically removed from the voltage divider, by closing the switch 130.

In the measurement configuration (not shown in Figure 1) of the sensor circuit 20, the switch 130 is closed and the calibration resistor 120 is thereby bridged and deactivated. The sensing capacitor 100 and the measurement resistor 110 are connected in series between the inner conductor 40 and electrical ground to form a voltage divider. When the inner conductor 40 is on a specific alternating voltage Vo, a certain current, the "measurement current", flows through the sensing capacitor 100 and the measurement resistor 110 to ground. A measurement voltage Vmeas can therefore be picked up between the first pickup contact 140 and the second pickup contact 141, i.e. across the measurement resistor 110. The measurement voltage Vmeas is proportional to, or more generally, it is indicative of the voltage of the inner conductor 40 versus ground.

The sensor circuit 20 is brought from the measurement configuration into the calibration configuration by opening the switch 130. In calibration configuration (shown in Figure 1) of the sensor circuit 20, the switch 130 is open and the calibration resistor 120 is thereby activated. The sensing capacitor 100, the calibration resistor 120 and the measurement resistor 110 are connected in series between the inner conductor 40 and electrical ground to form a voltage divider. When the inner conductor 40 is on the same alternating voltage Vo mentioned above, a certain current, the "calibration current", which is lower than the measurement current, flows through the sensing capacitor 100, the calibration resistor 120 and the measurement resistor 110 to ground. A calibration voltage Vcal can therefore be picked up between the first pickup contact 140 and the second pickup contact 141, i.e. across the measurement resistor 110.

The measurement resistor 110 and the calibration resistor 120 are selected such that their respective resistance values are known to a very high degree of precision. Since the resistances of the measurement resistor 110 and the calibration resistor 120 are precisely known, the capacitance of the sensing capacitor 100, and therewith the dividing ratio of the voltage divider, can be determined with a high degree of precision. By applying known formulae for voltage dividers both to the circuit in measurement mode and in calibration mode at the same alternating voltage Vo of the inner conductor 40, and taking into account the measurement voltage Vmeas and the calibration voltage Vcal, the dividing ratio at the time of taking Vmeas and Vcal can be determined. It is advantageous to arrange the measurement resistor 110 and the calibration resistor 120 geometrically away from the inner conductor 40, such that a temperature change of the inner conductor 40 does not affect the electrical properties of the measurement resistor 110 and of the calibration resistor 120. Such a setup will increase the accuracy of the determination of the capacitance of the sensing capacitor and of the dividing ratio of the voltage divider.

In order to determine precisely the instantaneous dividing ratio of the voltage divider, the calibration resistor 120 is deactivated by closing the switch 130, Vmeas is taken between the pickup contacts 140, 141 at a certain alternating voltage Vo of the inner conductor 40, and the measurement current Imeas is determined. Within a short time interval thereafter, the calibration resistor 120 is activated by opening the switch 130, Vcal is taken at the same voltage Vo of the inner conductor 40, and the calibration current Ical is determined. For these two measurements, the following formulae apply:

$$Vo = (Z_{100} + Z_{110}) \times I_{meas} \qquad \text{(measurement configuration)}$$

$$Vo = (Z_{100} + Z_{110} + Z_{120}) \times I_{cal} \qquad \text{(calibration configuration)}$$

wherein

Vo is the instantaneous voltage of the power conductor 40 versus ground;
$Z_{100}$ is the unknown (complex) impedance of the sensing capacitor 100;
$Z_{110}$ is the known (complex) impedance of the measurement resistor 110;
$Z_{120}$ is the known (complex) impedance of the calibration resistor 120;
$I_{meas}$ is the measurement current; and
$I_{cal}$ is the calibration current.

The measurement current and the calibration current are determined by picking up, between the pickup contacts 140, 141, the measurement voltage Vmeas in measurement configuration, and the calibration voltage Vcal in the calibration configuration. With the impedances and the resistances of the measurement resistor 110 and of the calibration resistor 120 being precisely known (as these are located away from the power conductor 40 and thus are not affected by temperature variations), the capacitance $C_{100}$ of the sensing capacitor 100 can then be determined from Vmeas and Vcal by using, for example, the following formulae

$$C_{100} = 1/(2\pi \, f_{MV} \, im(Z_{100}))$$

wherein

$$Z_{100} = \frac{V_{cal} ((Z_{120} / Z_{110})+1) \ - \ V_{meas}}{(V_{meas} / Z_{110}) - (V_{cal} / Z_{110})}$$

and wherein

$C_{100}$      is the capacitance of the sensing capacitor 100;
$f_{MV}$      is the oscillating frequency of the medium voltage on the power conductor 40;
$Z_{100}$      is the (complex) impedance of the sensing capacitor 100;
$im(Z_{100})$      is the imaginary part of $Z_{100}$;
$V_{meas}$      is the voltage drop across the measurement resistor 110 caused by the measurement current $I_{meas}$;
$V_{cal}$      is the voltage drop across the measurement resistor 110 caused by the calibration current $I_{cal}$;
$Z_{110}$      is the (complex) impedance of the measurement resistor 110; and
$Z_{120}$      is the (complex) impedance of the calibration resistor 120.

Formulae for computing the dividing ratio of voltage dividers and capacitance of sensing capacitors in voltage dividers under various conditions are generally known. In this embodiment, the measurement voltage Vmeas and the calibration voltage Vcal are recorded within such a short time interval, typically fractions of a second, that the capacitance of the sensing capacitor 100 remains essentially unchanged by temperature effects or other effects over that interval. Computing a precise, instantaneous value of the capacitance of the sensing capacitor 100 at a certain temperature of the sensing capacitor 100, allows to compute the instantaneous value of the dividing ratio of the voltage divider, and thereby allows to compute the instantaneous value of the voltage of the inner conductor 40 versus ground, using known formulae. The measurement voltage Vmeas and the calibration voltage Vcal can, for example, be recorded within such a short time interval, that the voltage Vo of the inner conductor 40 remains essentially unchanged within this interval. Alternatively, the measurement voltage Vmeas can be recorded at a time when the voltage of the inner conductor reaches Vo, and the calibration voltage Vcal can be recorded at a later time, when the voltage of the inner conductor reaches Vo again at a later time, provided that the time interval between the two recordings is short enough, so that the capacitance of the sensing capacitor 100 remains essentially unchanged by temperature effects or other effects over that time interval.

In the embodiment shown in Figure 1, the inner conductor 40 is on an AC voltage of approximately 10 kilovolt which oscillates at approximately 50 Hertz. The sensing capacitor 100 has a capacitance of approximately 15 pF (picofarad), the measurement resistor has a resistance of approximately 64 kΩ (kilo ohm), and the calibration resistor has a resistance of approximately 31 Ω (ohm). This setup brings Vmeas into the range of approximately 3 Volt and Vcal into the range of approximately 2.6 Volt.

In **Figure 2,** a second voltage sensing assembly 2 is shown in a figurative circuit diagram of the type used for Figure 1. The voltage sensing assembly 2 is identical to the first voltage sensing assembly 1, except that the calibration resistor 120 and the switch 130 are electrically arranged in parallel to the measurement resistor 110, and the first pickup contact 140 is arranged in a different place. The sensor circuit 20 is shown in the measurement configuration. For bringing the sensor circuit 20 into the calibration configuration (not shown in Figure 2), the switch 130 is closed, so that a calibration current flows through the sensing capacitor 100 and through both resistors 110, 120 to ground. When the calibration current flows, a calibration voltage can be picked up between the first pickup contact 140 and the second pickup contact 141. The calibration voltage allows to determine the calibration current, which in turn is indicative of the capacitance of the sensing capacitor 100 in a similar way as described above.

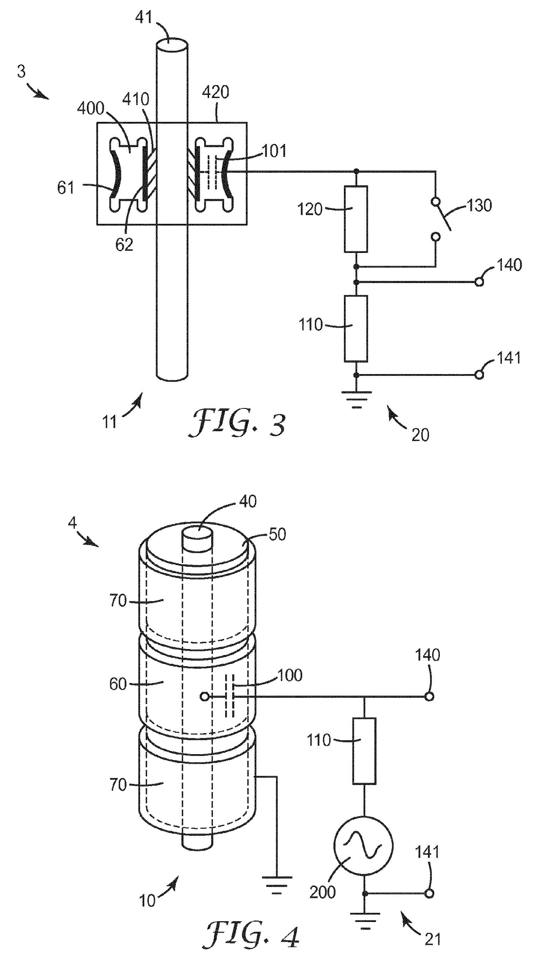

Figure 3 shows, in a figurative circuit diagram, an alternative voltage sensing assembly 3 according to the invention, in which the conductor assembly 11 comprises a power conductor 41 which has no insulation in at least an axial portion of it. The conductor assembly 11 may be, for example, a cable without insulation or a bus bar. In this embodiment, the sensing capacitor 101 has a second sensing electrode which is separate from the power conductor 41.

The sensor circuit 20 is electrically identical to the corresponding circuit 20 explained in the context of Figure 1 and will therefore not be explained again here. The physical elements of the sensing capacitor 101, however, are different from the elements of the sensing capacitor explained in the context of Figure 1.

The sensing capacitor 101 is shown in cross section. It comprises a toroidal or doughnut-shaped body 400, arranged coaxially around the power conductor 41. The body 400 comprises a non-conductive ceramic material as its main support. The ceramic material is operable as the dielectric of the sensing capacitor 101. The body 400 further comprises an electrically conductive inner surface, oriented radially inward towards the power conductor 41, and an electrically conductive outer surface, oriented radially outward, away from the power conductor 41. The outer surface is operable as the first sensing electrode 61 of the sensing capacitor 101. The inner surface is operable as the second sensing electrode 62 of the sensing capacitor 101. The second sensing electrode 62 is electrically and galvanically connected with the power conductor 41. The electrical connection between the second sensing electrode 62 and the power conductor 41 is effected via an electrically conductive contact element 410. The contact element 410 is resilient and comprises a plurality of conductive metal lamellae which are in mechanical and electrical contact with the second sensing electrode 62 in one portion, and with the power conductor 41 in another portion of the lamellae. Due to the electrical connection, the second sensing electrode 62 is on the same electrical potential as the power conductor 41. Although the sensing capacitor 101 does not use the power conductor 41 as the second sensing electrode but has a separate second sensing electrode 62, the voltage sensing assembly 3 shown in Figure 3 is electrically identical to the voltage sensing assembly 1 of Figure 1. The same methods for determining the capacitance of the sensing capacitor 101 and for determining the voltage of the power conductor 41 versus ground can therefore be applied.

The sensing capacitor 101 in this embodiment is accommodated in a protective housing 420 or in a moulded body 420 such as a splice body. This may be done with the sensing capacitors 100 of other embodiments described above or below in a similar manner.

In the embodiments shown in Figures 1 and 2, the sensor circuit is brought from the measurement configuration into the calibration configuration by operating the switch 130, thereby activating the calibration resistor 120. Activation of the calibration resistor 120 changes the current through the first sensing electrode 60 to ground, i.e. the current through the sensing capacitor 100 to ground, from the measurement current to the calibration current. In a further embodiment of a voltage sensing assembly according to the invention, shown in **Figure 4,** a change in current through the first sensing electrode 60 to ground is achieved by activating a voltage source. This fourth voltage sensing assembly 4 is identical to the voltage sensing assembly 1 of Figure 1, except that the calibration resistor 120 and the switch 130 have been removed and a calibration voltage source 200 has been added to the sensor circuit 21. The calibration voltage source 200 is electrically connected between the measurement resistor 110 and ground. In this embodiment, the sensor circuit 21 comprises the sensing capacitor 100, the measurement resistor 110 and the calibration voltage source 200.

The calibration voltage source 200 can be activated for bringing the sensor circuit 21 into the calibration configuration, and deactivated for bringing the sensor circuit 21 into the measurement configuration. In its deactivated state, the calibration voltage source 200 provides a short between its output contacts and thus does not add any voltage to the electrical connection between the measurement resistor 110 and ground. In this deactivated state, the measurement resistor 110 is connected directly to ground, through the calibration voltage source 200. The calibration voltage source 200 does not necessarily have to be switched off in order to be deactivated. It is sufficient for the present invention if the voltage source 200 does not provide any voltage or any additional voltage between its output contacts.

In its activated state, i.e. in the calibration configuration of the sensor circuit 21, the calibration voltage source 200 provides a precisely-known voltage between its output contacts. The calibration voltage source 200 thus adds a (positive or negative) voltage, e.g. an AC or a DC voltage, to the electrical connection between the measurement resistor 110 and ground. The voltage added by the voltage source 200 changes the current flowing through the second sensing electrode 60 of the sensing capacitor 100, i.e. through the sensing capacitor 100, and through the measurement resistor 110 to ground.

In the measurement configuration, the calibration voltage source 200 is deactivated. The sensing capacitor 100 and the measurement resistor 110 are therefore connected in series between the medium voltage of the inner conductor 40 and electrical ground to form a voltage divider. When the inner conductor 40 is on a specific voltage Vo, a certain current, the "measurement current", flows through the sensing capacitor 100, the measurement resistor 110 and through the deactivated calibration voltage source 200 to ground. A measurement voltage Vmeas can therefore be picked up between the first pickup contact 140 and the second pickup contact 141, i.e. across the measurement resistor 110 and the deactivated calibration voltage source 200. The measurement voltage Vmeas is proportional to, or more generally, it is indicative of the voltage of the inner conductor 40 versus ground.

In the calibration configuration, the calibration voltage source 200 is activated. The sensing capacitor 100, the measurement resistor 110 and the calibration voltage source 200 are connected in series between the inner conductor 40 and electrical ground to form a voltage divider. When the inner conductor 40 is on the same voltage Vo mentioned in the previous paragraph, a certain current, the "calibration current", flows through the sensing capacitor 100, the measurement resistor 110 and the calibration voltage source 200 to ground. A calibration voltage Vcal can therefore be picked up between the first pickup contact 140 and the second pickup contact 141, i.e. across the measurement resistor 110 and the calibration voltage source 200.

The measurement resistor 110 is selected such that its resistance value is known to a very high degree of precision. Similarly, the output voltage of the calibration voltage source 200 is known to a high degree of precision. By applying known formulae for voltage dividers both to the sensor circuit 21 in measurement configuration and in calibration configuration at the same voltage Vo of the inner conductor 40, and taking into account the measurement voltage Vmeas and the calibration voltage Vcal, the capacitance of the sensing capacitor 100 at the time of taking Vmeas and Vcal can be determined. Similarly, the dividing ratio of the voltage divider formed by the sensing capacitor 100 and the measurement resistor 110 can be determined. Since the resistance of the measurement resistor 110 and the output voltage of the calibration voltage source 200 are precisely known, the capacitance of the sensing capacitor 100, and therewith the dividing ratio of the voltage divider circuit 21, can be determined with a high degree of precision.

In order to determine precisely the instantaneous dividing ratio of the voltage divider circuit 21, the sensor circuit 21 is first brought into the measurement configuration, i.e. the voltage source 200 is deactivated, and Vmeas is taken between the pickup contacts 140, 141 at a certain voltage Vo of the inner conductor 40, and the measurement current Imeas is determined. Within a short time interval, the sensor circuit 21 is then brought into the calibration configuration, i.e. the voltage source 200 is activated and provides a voltage $V_{200}$. The calibration voltage Vcal is measured between the pickup contacts 140, 141 at the same voltage Vo of the inner conductor 40, and the calibration current Ical is determined. The calibration voltage Vcal measured between the pickup contacts 140, 141 when the voltage source 200 is activated, is higher or lower by an amount $\Delta V$ than the voltage measured when the voltage source 200 is deactivated. For the measurement configuration and the calibration configuration, the following formulae apply, in analogy to the formulae explained in the context of Figure 1:

$$Vo = (Z_{100} + Z_{110}) \times I_{meas} \qquad \text{(measurement configuration)}$$

$$Vo = (Z_{100} + Z_{110}) \times I_{cal} - V_{200} \qquad \text{(calibration configuration)}$$

The capacitance of the sensing capacitor 100 can then be determined by using, for example, the following formula

$$C_{100} = (1/2\pi \, f_{MV}) * (((\Delta V / (Z_{110} * V_{200})) - Z_{110})$$

wherein

    $C_{100}$ is the capacitance of the sensing capacitor 100;
    $f_{MV}$ is the oscillating frequency of the high voltage Vo of the inner conductor 40;
    $Z_{110}$ is the impedance of the measurement resistor 110;
    Vo is the instantaneous voltage of the inner conductor 40;
    $V_{meas}$ is the voltage between contacts 140, 141 in measurement configuration;
    $V_{cal}$ is the voltage between contacts 140, 141 in the calibration configuration;
    $\Delta V = V_{cal} - V_{meas}$, voltage measured on top of $V_{meas}$ in the calibration configuration;
    $V_{200}$ is the voltage output by the calibration voltage source 200 in activated state.

It is advantageous to determine Vcal and Vmeas within a short time interval, as was described above for the first embodiment. Again, different ways can be used to perform the determination of Vmeas and Vcal at the same voltage Vo of the inner conductor 40, as is described above in the context of Figure 1. At the time when Vcal is determined, it is advantageous if the output voltage of the voltage source does not change quickly. A slowly-changing or even constant output voltage allows for more precise determination of the output voltage at the moment of taking Vcal. This in turn allows for a more precise determination of the capacitance of the sensing capacitor 100, of the instantaneous dividing ratio of the voltage divider circuit 21 and thereby of the voltage of the inner conductor 40.

In an alternative sensor circuit (not shown), the calibration voltage source 200 may be electrically arranged in parallel to the measurement resistor 110. When the calibration voltage source 200 is activated, it again changes the current through the sensing capacitor 100 and the measurement resistor 110 to ground. Similar formulae to the ones described above may be used to calculate the capacitance of the sensing capacitor 100 in this alternative sensor circuit.

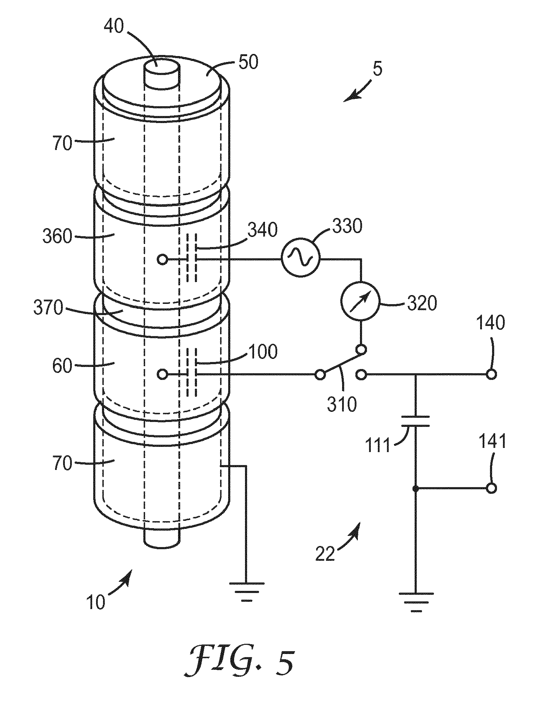

In the embodiment shown in Figure 4, the activation of the calibration voltage source 200 changes the current through the first sensing electrode 60 to ground, i.e. the current through the sensing capacitor 100 to ground, from the measurement current to the calibration current. In a fifth embodiment of a voltage sensing assembly according to the invention, shown in **Figure 5,** a change in current through the first sensing electrode 60 to ground is achieved by connecting the sensing capacitor 100 to a calibration capacitor and by activating a voltage source. The voltage sensing assembly 5 of this embodiment is different from the first and the second embodiment at least in that the sensing capacitor 100 is electrically disconnected from the measurement impedance during calibration.

In the voltage sensing assembly 5 shown in Figure 5, the sensor circuit 22 comprises the sensing capacitor 100 and a measurement capacitor 111. These capacitors 100, 111 are electrically connected in series. The sensor circuit 22 further comprises the sensing capacitor 100 with its first sensing electrode 60, a switch 310, a voltage measurement device 320, a calibration voltage source 330 and calibration capacitor 340.

As in the previous embodiments, the sensing capacitor 100 is formed by the inner conductor 40 of the cable 10 as the second sensing electrode, by a layer of conductive material on the insulating layer 50 of the cable 10 as the first sensing electrode 60, and by a portion of the pre-existing insulating layer 50 of the cable 10 as dielectric.

In a similar way as the sensing capacitor 100, the calibration capacitor 340 is formed by the inner conductor 40 of the cable 10 as the second calibration electrode, by a layer of conductive material on the insulating layer 50 of the cable 10 as the first calibration electrode 360, and by a different portion of the insulating layer 50 as dielectric. The calibration capacitor 340 is arranged on the same cable 10 as the sensing capacitor 100, generally in the same section of the cable 10, but axially offset from the sensing capacitor 100. The first calibration electrode 360 is separated from the first sensing electrode 60 by a non-conductive gap 370. The sensing capacitor 100 and the calibration capacitor 340 use the inner conductor 40 of the cable 10 as their respective second electrode, so that electrically these capacitors 100, 340 are connected in series with each other. Like in the previous embodiments, auxiliary electrodes 70 provide for a more homogenous electrical field. Also the auxiliary electrodes 70 are formed by respective layers of conductive material on the pre-existing insulation layer 50 of the cable 10.

The sensing capacitor 100 and the calibration capacitor 340 are located geometrically close to each other in similar geometrical arrangements. Temperature effects on the cable 10 or in the environment will therefore affect both capacitors 100, 340 in the same manner. The sensing capacitor 100 and the calibration capacitor 340 are considered thermally coupled with each other, because they share the inner conductor 40 of the cable and the insulation layer 50, which are thermally conductive to some degree. It can therefore be assumed that the sensing capacitor 100 and the calibration capacitor 340 are on the same temperature. Any change in temperature is deemed to affect the capacitances of these capacitors 100, 340 in the same way, so that the ratio of their capacitances can be assumed to be equal for all temperatures within a wide range.

Generally, and in all embodiments described herein, after assembly of the voltage sensing assembly 5, an initial calibration is performed with the sensor circuit in its calibration configuration. This earlier calibration provides a starting value for the capacitance of the sensing capacitor. At a later time, when an accurate determination of the voltage of the power conductor 40 is required, a further calibration is performed in calibration configuration, and shortly thereafter a measurement is performed in measurement configuration. Taking into account the results of the earlier calibration, the later calibration yields an accurate value of the instantaneous capacitance of the sensing capacitor 100. This value is then used to correct the measurement of the voltage of the power conductor obtained in the measurement mode.

In its calibration configuration shown in Figure 5, the sensor circuit 22 serves to measure the common serial capacity of the sensing capacitor 100 and the calibration capacitor 340, which are electrically connected in series. The calibration voltage source 330 and the voltage measurement device 320 serve to measure this serial capacity. The calibration voltage source 330 provides an alternating voltage of 10 Volts at a frequency of 50 kHz, which is a much higher frequency than the 50 Hz frequency at which the voltage of the power conductor oscillates. With the switch 310 in the upper position (in the Figure), the voltage measurement device 320 measures the resulting voltage across the sensing capacitor 100 and the calibration capacitor 340.

After performing the calibration, the sensor circuit 23 is brought into the measurement configuration by bringing the switch 310 into the lower position (not shown in Figure 5). In this position, the voltage divider, comprising the sensing capacitor 100 and a measurement impedance, is operable to sense an alternating voltage of the inner conductor 40 versus ground, as described before. The measurement impedance is, in this embodiment, the measurement capacitor 111. It is electrically arranged between the first sensing electrode 60 and ground. When the inner conductor 40 is on a specific alternating voltage Vo, a certain current, the "measurement current", flows through the sensing capacitor 100 and the measurement capacitor 111 to ground. A measurement voltage Vmeas can therefore be picked up between the first pickup contact 140 and the second pickup contact 141, i.e. across the measurement capacitor 111. The measurement voltage Vmeas is proportional to, or more generally, it is indicative of the voltage of the inner conductor 40 versus ground.

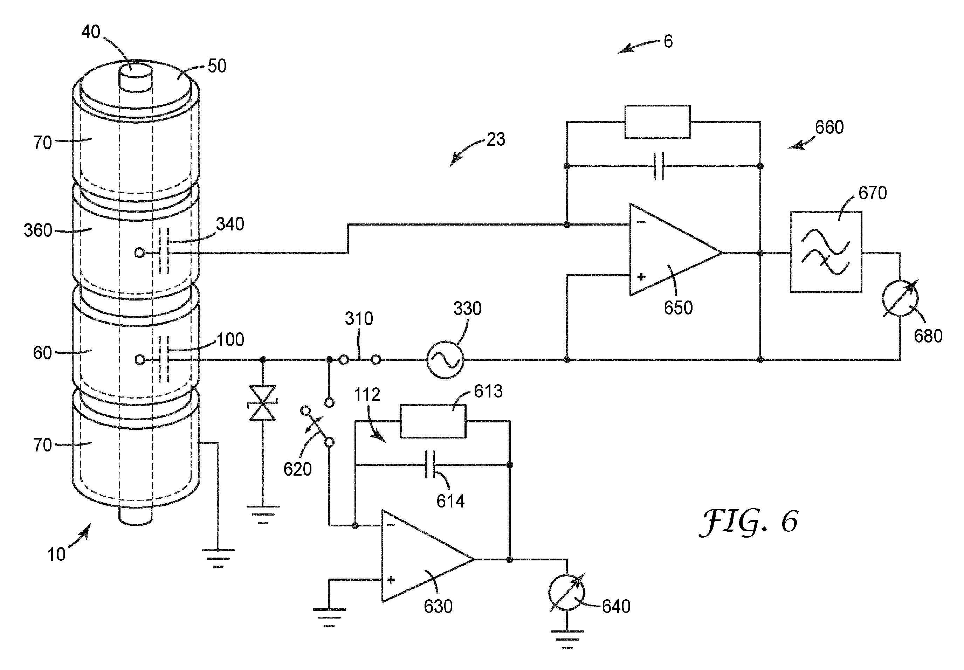

In the embodiment shown in Figure 5, during assembly of the voltage sensing assembly 5, i.e. required only once, the capacitances of the sensing capacitor 100 and the calibration capacitor 340 and their ratio is determined, using known techniques. This ratio r=C100assy/C340assy can be assumed to be essentially constant over time and over a wide temperature range. Preferably, this ratio is r=1, as it makes subsequent computations easier. Also right after assembly, the sensor circuit 23 in its calibration configuration is used to measure an initial calibration current lassy by activating the calibration voltage source 330, having it provide a specific output voltage V330 at 50 kHz, and determining the initial calibration current lassy through the sensing capacitor 100 and the calibration capacitor 340. It is to be noted that the calibration after assembly and the further calibration before a voltage measurement, described below, can be performed at different voltages of the power conductor without affecting the precision of the result, because a high-pass filter like the high-pas filter 670 shown in Figure 6 can be used to remove any influence of the slowly-changing 50 Hz voltage of the power conductor 40, so that the calibration is virtually using the high-frequency 50 kHz voltage supplied by the calibration voltage source 330 only.

For a further calibration just before measuring the voltage of the power conductor 40, the sensor circuit 22 is brought into the calibration configuration (shown in Figure 5) by operating the switch 310 for connecting the calibration capacitor 340 and the calibration voltage source 330 to the sensing capacitor 100, and disconnecting the measurement capacitor 111 from the sensing capacitor 100. The calibration voltage source 330 provides the same specific output voltage V330 as in the initial calibration stage right after assembly. The output voltage V330 supplied by the calibration voltage source 330 is known to a high degree of accuracy across a wide temperature range. Optionally, the sensor circuit 22 comprises additional electrical elements that allow accurate measurement of the output voltage V330 provided by the calibration voltage source 330. With the calibration voltage source 330 activated, a calibration current Inow flows through the sensing capacitor 100 and the calibration capacitor 340. Inow can be determined via the voltage measurement device 320. Alternatively, Inow can be measured using an operational amplifier ("OpAmp"), an impedance circuit and a high-pass filter, like the OpAmp 650, the impedance circuit 660 and the high-pass filter 680 shown in Figure 6.

If r=1, i.e. if the capacitances of the sensing capacitor 100, C100assy, and of the calibration capacitor 340, C340assy, at the time of assembly are equal, the instantaneous capacitance C100now of the sensing capacitor 100 can be determined by using the values for Iassy and C100assy obtained in initial calibration right after assembly, and by applying, for example, the following formula

$$C_{100now} = (I_{now}/I_{assy}) \times C_{100assy}$$

Wherein

$C_{100now}$ is the instantaneous capacitance of the sensing capacitor 100;
$I_{now}$ is the calibration current measured at the present time of calibration;
$I_{assy}$ is the calibration current measured at the time of assembly; and
$C_{100assy}$ is the capacitance of the sensing capacitor 100 at the time of assembly.

This calibration yields the instantaneous capacitance of the sensing capacitor 100. After performing the calibration, the sensor circuit 22 is brought into the measurement configuration by operating the switch 310, such as to disconnect the calibration voltage source from the measurement capacitor 111 and to connect the sensing capacitor 100 to the measurement capacitor 111 to form the voltage divider. In this position, the voltage divider, comprising the sensing capacitor 100 and the measurement capacitor 111, is operable to sense an alternating voltage of the inner conductor 40 versus ground, as described before.

Being arranged close to each other on the cable 10, the capacitances of the sensing capacitor 100 and of the calibration capacitor 340 are affected by temperature changes of the cable 10 in the same manner, so that the ratio of their capacitances remains essentially constant with temperature. The measurement capacitor 111 is not affected by these temperature changes, because it is arranged at a sufficient distance away from the cable 10.

Figure 6 is a figurative circuit diagram of a sixth voltage sensing assembly 6 according to the invention. The conductor assembly 10 is identical to the conductor assembly shown in Figure 5, as are the sensing capacitor 100, and the calibration capacitor 340. The sensor circuit 23, however, is more elaborate than the one shown in Figure 5, in order to achieve an even higher accuracy. The measurement principle, however, is the same.

The upper part of the sensor circuit 23 comprises a calibration voltage source 330, a first OpAmp 650, an circuit 660 comprising a resistor and a capacitor, a high pass filter 670 and a voltage measurement device 680. The first OpAmp 650, the impedance circuit 660 and the voltage measurement device 680 form a secondary circuit which serves to measure the calibration current Inow, i.e. the current caused by the calibration voltage source 330 through the sensing capacitor 100 and through the calibration capacitor 340. These elements thus can be considered to replace the voltage measurement device 320 in Figure 5.

The high pass filter 670 serves to eliminate low-frequency variations in the calibration current, that result from the relatively slowly changing 50Hz voltage of the power conductor 40.

The lower part of the sensor circuit 23 comprises a measurement impedance circuit 112, which in turn comprises a measurement resistor 613 and a measurement capacitor 614, electrically connected in parallel. The measurement impedance circuit 112 and the sensing capacitor 100 form a voltage divider for dividing the comparatively high voltage of the power conductor 40 versus ground. They replace the measurement capacitor 111 in Figure 5.

A second operational amplifier ("OpAmp") 630 and a voltage measurement device 640 serve to measure the measurement current from the power conductor 40 through the sensing capacitor 100 and the measurement impedance circuit 112 to ground. The measurement current is indicative of the voltage of the power conductor 40 versus ground.

A second switch 620 serves to separate the measurement impedance circuit 112 from the sensing capacitor 100 in the calibration configuration (shown in Figure 6), so that calibration results are not impacted by the presence of the measurement impedance circuit 112 shown in the lower part of the Figure.

In the measurement configuration (not shown in Figure 6), the first switch 310 is opened and the second switch 620 is closed and thereby electrically connects the measurement impedance circuit 112 with the sensing capacitor 100. The first switch 310 is opened, in order to avoid interference of electrical elements in the calibration circuit (i.e. the upper part of the sensor circuit 23), which are only required for calibration, with the measurement. In the measurement configuration, the measurement impedance circuit 112 is electrically arranged between the first sensing electrode 60 and electrical ground. The measurement impedance circuit 112 and the sensing capacitor 100 form a voltage divider for dividing the high voltage of the power conductor 40 versus ground.

For calibration in the calibration configuration, the calibration voltage source 330 is activated and then provides an alternating voltage of about 10 Volt at a frequency of about 50 kHz. The voltage measurement device 680 determines a value for the calibration current through the serially-coupled capacitors 100, 340. The value of the calibration current can be used to compute an accurate value of the capacitance of the sensing capacitor 100, using formulas similar to the ones explained above. This accurate value can then be used for determining an accurate dividing ratio of the voltage divider. The dividing ratio and a value of the measurement current can be used for computing an accurate value of the voltage of the power conductor 40 versus ground.

Overvoltage protection circuits, as the one shown left of the second switch 620, can be introduced into the sensor circuit 23 in order to protect sensitive electrical elements against high voltages in the peaks of the 50 Hz medium-voltage oscillation on the power conductor 40. Any measurements in the measurement configuration then need to be performed in the voltage regime not cut off by the overvoltage protection circuits.

**Claims**

1. Voltage sensing assembly (1, 2, 3, 4), comprising a conductor assembly (10, 11) having a power conductor (40, 41) for conducting power in a high-or medium voltage power network, and a sensor circuit (20, 21, 22, 23) for sensing an alternating voltage of the power conductor,
   wherein the sensor circuit comprises

   a) a sensing capacitor (100, 101) having a capacitance and comprising a first sensing electrode (60, 61), a dielectric, and a second sensing electrode (62) electrically connected with the power conductor (41) or comprising a portion of the power conductor (40); and
   b) a measurement impedance (110, 111), electrically arranged, in series with the sensing capacitor, between the first sensing electrode and electrical ground such that the sensing capacitor and the measurement impedance form a voltage divider,

   wherein the sensor circuit can be brought into a measurement configuration, in which a measurement current, flowing through the measurement impedance, is indicative of the voltage of the power conductor versus ground, **characterized in that** the sensor circuit can be brought into a calibration configuration, in which a calibration current, flowing through the first sensing electrode, is indicative of the capacitance of the sensing capacitor.

2. Voltage sensing assembly according to claim 1, wherein the conductor assembly comprises an insulation layer (50) arranged coaxially around the power conductor, and wherein the dielectric of the sensing capacitor comprises a first portion of the insulation layer.

3. Voltage sensing assembly according to claim 1 or claim 2, wherein in the calibration configuration and/or in the measurement configuration the second sensing electrode is galvanically separated from all other elements of the sensor circuit.

4. Voltage sensing assembly according to any one of the preceding claims, wherein the sensor circuit is adapted such that, for the same voltage of the power conductor, in the measurement configuration a current through the second sensing electrode to ground is different than in the calibration configuration.

5. Voltage sensing assembly according to any one of the preceding claims, further comprising a cover (420) forming a receiving space, wherein at least a portion of the conductor assembly and the sensing capacitor are arranged in the receiving space.

6. Voltage sensing assembly according to any one of the preceding claims, wherein the sensor circuit comprises a calibration resistor (120), electrically arranged in series with the measurement impedance when the sensor circuit is in the calibration configuration.

7. Voltage sensing assembly according to any one of the preceding claims, wherein the sensor circuit comprises a calibration voltage source (200), electrically arranged in series with, or parallel to, the measurement impedance when the sensor circuit is in the calibration configuration.

8. Voltage sensing assembly according to any one of the preceding claims, wherein the sensor circuit comprises a calibration capacitor (340), comprising a first electrode, a second electrode (360) and a dielectric, and electrically arranged in series with the sensing capacitor (100) when the sensor circuit is in the calibration configuration.

9. Voltage sensing assembly according to claim 8, wherein the conductor assembly comprises an insulation layer (50), and wherein the dielectric of the calibration capacitor (340) comprises a portion of the insulation layer.

10. Voltage sensing assembly according to claim 8 or claim 9, wherein the second electrode (360) of the calibration capacitor (340) is electrically connected with the second sensing electrode by a portion of the power conductor.

11. Voltage sensing assembly according to any one of claims 8 to 10, wherein the calibration capacitor (340) is thermally coupled to the sensing capacitor (100).

12. Voltage sensing assembly according to any one of the preceding claims, wherein the conductor assembly comprises a medium-voltage or high-voltage power cable (10), and wherein the power conductor comprises an inner conductor (40) of the power cable.

13. Voltage sensing assembly according to any one of the preceding claims, wherein the conductor assembly comprises a bus bar (41).

14. Voltage sensing assembly according to any one of the preceding claims, wherein the conductor assembly comprises an insulation layer (50), and wherein the first sensing electrode (60) is arranged directly on the insulation layer.

15. Method of determining the capacitance of a sensing capacitor (100, 101), comprised in a sensor circuit (20, 21, 22) for sensing a voltage of a conductor assembly (10, 11) for conducting power in a high- or medium voltage power network,
   wherein the sensing capacitor has a capacitance and comprises a second sensing electrode (62), galvanically connected with a power conductor of the conductor assembly, a dielectric, and a first sensing electrode (60, 61),
   wherein a measurement impedance (110, 111) is electrically connected between the second sensing electrode and electrical ground, the sensing capacitor and the measurement impedance forming a voltage divider,
   the method comprising the steps, in this sequence, of

   a) bringing the sensor circuit into a calibration configuration and determining a value of a calibration current flowing through the second sensing electrode at a given voltage of the inner conductor versus ground,
   b) calculating the capacitance of the sensing capacitor by using the value of the calibration current.

FIG. 1

FIG. 2

*FIG. 3*

*FIG. 4*

FIG. 5

FIG. 6

EP 2 993 480 A1

Europäisches
Patentamt
European
Patent Office
Office européen
des brevets

**EUROPEAN SEARCH REPORT**

Application Number

EP 14 18 3485

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2012/059335 A1 (ALSTOM TECHNOLOGY LTD [CH]; HOBELSBERGER MAX [CH]) 10 May 2012 (2012-05-10) | 1-5,7, 12-15 | INV. G01R15/06 G01R15/16 |
| Y | * abstract; figures 1-8 * <br> * page 2, line 20 - page 3, line 20 * <br> * page 5, line 1 - page 10, line 19 * <br> ----- | 8-11 | |
| Y | WO 2008/052495 A1 (SIEMENS AG [DE]; JURISCH ANDREAS [DE]) 8 May 2008 (2008-05-08) * figures 1-6 * <br> ----- | 8 | |
| Y | US 5 017 859 A (ENGEL JOSEPH C [US] ET AL) 21 May 1991 (1991-05-21) * abstract; figures 1-4 * <br> * column 2, line 10 - line 52 * <br> ----- | 9-11 | |
| A | US 2014/159701 A1 (NABIELEC JERZY [PL]) 12 June 2014 (2014-06-12) * abstract; figures 1-5 * <br> * paragraphs [0009] - [0014] * <br> ----- | 1-15 | |

TECHNICAL FIELDS
SEARCHED      (IPC)

G01R

The present search report has been drawn up for all claims

| Place of search | Date of completion of the search | Examiner |
|---|---|---|
| Munich | 24 February 2015 | Kleiber, Michael |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 14 18 3485

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2015

| Patent document cited in search report | | Publication date | Patent family member(s) | | Publication date |
|---|---|---|---|---|---|
| WO 2012059335 | A1 | 10-05-2012 | AR | 083550 A1 | 06-03-2013 |
| | | | CA | 2815403 A1 | 10-05-2012 |
| | | | CN | 103201635 A | 10-07-2013 |
| | | | EP | 2635910 A1 | 11-09-2013 |
| | | | TW | 201229533 A | 16-07-2012 |
| | | | US | 2013234726 A1 | 12-09-2013 |
| | | | WO | 2012059335 A1 | 10-05-2012 |
| WO 2008052495 | A1 | 08-05-2008 | CN | 101535818 A | 16-09-2009 |
| | | | DE | 112006004041 A5 | 02-07-2009 |
| | | | HK | 1131441 A1 | 21-09-2012 |
| | | | WO | 2008052495 A1 | 08-05-2008 |
| US 5017859 | A | 21-05-1991 | NONE | | |
| US 2014159701 | A1 | 12-06-2014 | CA | 2843953 A1 | 28-02-2013 |
| | | | EP | 2745121 A1 | 25-06-2014 |
| | | | JP | 2014521980 A | 28-08-2014 |
| | | | KR | 20140049551 A | 25-04-2014 |
| | | | US | 2014159701 A1 | 12-06-2014 |
| | | | WO | 2013026805 A1 | 28-02-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4241373 A

- EP 2508898 A1